# EUROPÄISCHE PATENTSCHRIFT

(11) **EP 3 066 903 B1**
(45) Veröffentlichungstag und Bekanntmachung des Hinweises auf die Patenterteilung: **17.04.2019**
(21) Anmeldenummer: 14793107.5
(22) Anmeldetag: 03.11.2014
(51) Int. Cl.: H05K 7/14

(54) **KOMPONENTENAUFBAUSYSTEM**
COMPONENT ASSEMBLY SYSTEM
SYSTÈME D'ASSEMBLAGE DE COMPOSANTS

(30) Priorität: 04.11.2013 DE 102013112101
(43) Veröffentlichungstag der Anmeldung: 14.09.2016
(73) Patentinhaber: Phoenix Contact GmbH & Co. KG, 32825 Blomberg (DE)
(72) Erfinder: BURY, Joachim, 31812 Bad Pyrmont (DE); SALOMON, Thomas, 33415 Verl (DE)
(74) Vertreter: Patentship Patentanwaltsgesellschaft mbH
(86) Internationale Anmeldenummer: PCT/EP2014/073573
(87) Internationale Veröffentlichungsnummer: WO 2015/063298

(56) Entgegenhaltungen:
- EP-A1- 2 157 845
- EP-A2- 0 896 504
- EP-A2- 1 587 352
- WO-A1-00/62376
- US-A- 4 269 471
- US-A- 5 741 142
- US-A1- 2009 023 320

## Beschreibung

Die vorliegende Erfindung betrifft ein Komponentenaufbausystem mit einer Tragprofilschiene und einem Brückenmodul zum elektrischen Verbinden einer Funktionskomponente des Komponentenaufbausystems.

Moderne Komponentensysteme der Automatisierungstechnik bestehen typischerweise aus einer Vielzahl von Funktionskomponenten, die in einem Schaltschrank angeordnet sind. Die Verteilerfunktionen für Energie und Daten sind mit getrennten Stecksystemen realisiert. Ein schaltschrankloser Aufbau ist nicht möglich, da Peripheriegeräte nahe dem Schaltschrank mit einer sternförmigen Energieverteilung hängen. Werden Feldbuskonzepte verwendet, bei denen einzelne Komponenten auf Rückplatten aufgesetzt werden, werden auf die Rückplatten hohe Gewichtskräfte ausgeübt.

Brückenelemente können zur elektrischen Verbindung von Funktionskomponenten verwendet werden. Diesen sind jedoch keine weiteren mechanischen Funktionen zugeordnet.

Die Druckschrift DE 30 30 906 A1 betrifft einen Umschalt-Brückenstecker. Der Umschalt-Brückenstecker umfasst zwei jeweils zwei Steckerstifte aufweisende Leitungsbrücken, die im Abstand der Steckerstifte paarweise jeweils parallel zueinander in einem gemeinsamen Steckerteil aus Isoliermaterial für Leiterbahnen auf einer Leiterplatte gehalten sind.

In der WO 00/62376 A1, ist eine Verbinderanordnung offenbart, welche auf einer Schiene angeordnet ist.

In der EP 0 896 504 A2 ist ein elektrisches oder elektronisches Gerät offenbart, welches zum Aufsetzen auf eine als Hutschiene ausgebildete Tragschiene vorgesehen ist.

In der US 2009/0023320 A1 ist ein modulares Feldbussystem mit einer Hauptstelle offenbart, wobei die Hauptstelle ein Hauptkommunikationsmodul aufweist, mit welchem E/A-Module elektrisch verbunden werden können.

Es ist die der Erfindung zugrundeliegende Aufgabe, ein Komponentenaufbausystem anzugeben, bei dem eine Montage der Komponenten vereinfacht wird.

Diese Aufgabe wird durch den Gegenstand mit den Merkmalen nach dem unabhängigen Anspruch gelöst. Vorteilhafte Ausführungsformen der Erfindung sind Gegenstand der Figuren, der Beschreibung und der abhängigen Ansprüche.

Gemäß einem Aspekt der Erfindung wird die Aufgabe durch ein modulares Komponentenaufbausystem mit einer Tragprofilschiene und zumindest einem Brückenmodul zum elektrischen Verbinden einer Funktionskomponente des Komponentenaufbausystems gelöst, das eine Modulrasteinrichtung zum Aufrasten des Brückenmoduls auf die Tragprofilschiene umfasst. Dadurch wird beispielsweise der technische Vorteil erreicht, dass ein gleicher mechanischer Aufbau auf Tragprofilschienen für Verbindungstechnik und Funktionskomponenten erzielt wird. Eine Verkabelung für alle im System vorkommenden Spannungen und den Steuerbus sowie jegliche weitere manuelle Verbindungstechnik untereinander entfällt. Ein Festsetzen der montierten Gruppen erfolgt durch Arretierungsmöglichkeiten sowohl am Brückenmodulanfang einer Gruppe als auch an einzelnen Funktionskomponenten.

Das Komponentenaufbausystem kann beispielsweise ein Feldbussystem sein.

Die Modulrasteinrichtung ist eine Ausführungsform einer Formschlussverbindung zum formschlüssigen Verbinden des Brückenmoduls mit der Tragprofilschiene. In den nachfolgend beschriebenen Ausführungsformen kann die Modulrasteinrichtung daher durch eine Formschlussverbindung verallgemeinert werden, wobei die Aufrastung eine Ausführungsform der formschlüssigen Verbindung ist.

In einer vorteilhaften Ausführungsform des Komponentenaufbausystems umfasst das Brückenmodul eine Aufnahmenut zum Einsetzen eines Einsatzabschnittes der Funktionskomponente, um Zugkräfte der Funktionskomponente entlang der Tragprofilschiene aufzunehmen. Durch die Aufnahmenut wird beispielsweise der technische Vorteil erreicht, dass eine Beschädigung der Steckkontakte durch Zugkräfte verhindert wird.

In einer weiteren vorteilhaften Ausführungsform des Komponentenaufbausystems umfasst die Modulrasteinrichtung einen die Tragprofilschiene umgreifenden starren Aufsetzabschnitt und einen gegenüber dem starren Aufsetzabschnitt angeordneten federelastischen Rastabschnitt zum Aufrasten auf die Tragprofilschiene umfasst. Dadurch kann das Brückenmodul auf die Tragprofilschiene rastend aufgeschwenkt werden.

Der elastische Rastabschnitt kann zum seitlichen Übergreifen der Tragprofilschiene ausgebildet sein. Dadurch wird beispielsweise der technische Vorteil erreicht, dass das Rastmittel an der Rückseite der Tragprofilschiene eingreifen kann und eine stabile Verbindung hergestellt wird.

In einer weiteren vorteilhaften Ausführungsform des Komponentenaufbausystems umfasst der Rastabschnitt eine Rastnase zum Hintergreifen der Tragprofilschiene. Dadurch wird beispielsweise der technische Vorteil erreicht, dass das Brückenmodul auf einfache Weise an der Rückseite der Tragprofilschiene aufgerastet und befestigt wird.

In einer weiteren vorteilhaften Ausführungsform des Komponentenaufbausystems ist der Rastabschnitt einstückig an dem Brückenmodul ausgebildet. Dadurch wird beispielsweise der technische Vorteil erreicht, dass das Brückenmodul mit dem Rastmittel in einem Arbeitsschritt hergestellt werden kann.

In einer weiteren vorteilhaften Ausführungsform des Komponentenaufbausystems umfasst der Rastabschnitt eine Ausnehmung zum Erhöhen einer Biegsamkeit des Rastabschnitts. Dadurch wird beispielsweise der technische Vorteil erreicht, dass der Rastabschnitt flexibel bei Aufrasten gebogen werden kann, obwohl das Brückenmodul aus einem relativ festen Material gebildet ist.

In einer weiteren vorteilhaften Ausführungsform des Komponentenaufbausystems umfasst das Brückenmodul eine Schienenaussparung zum Einsetzen einer Kante der Tragprofilschiene. Dadurch wird beispielsweise der technische Vorteil erreicht, dass das Brückenmodul mit der Schienenaussparung in der vorgesehenen Position an die Tragprofilschiene gehängt werden kann.

In einer weiteren vorteilhaften Ausführungsform des Komponentenaufbausystems ist die Schienenaussparung an einer Stirnseite des Brückenmoduls angeordnet und die Modulrasteinrichtung ist an einer gegenüberliegenden Stirnseite des Brückenmoduls angeordnet. Dadurch wird beispielsweise der technische Vorteil erreicht, dass das Brückenmodul zunächst an die Tragprofilschiene gehängt werden kann und anschließend mit einer Drehbewegung aufgerastet werden kann.

In einer weiteren vorteilhaften Ausführungsform des Komponentenaufbausystems ist die Modulrasteinrichtung mittig an einer oder zwei gegenüberliegenden Stirnseiten des Brückenmoduls angeordnet. Dadurch wird beispielsweise der technische Vorteil erreicht, dass sich die Kräfte gleichmäßig vom Brückenmodul auf die Tragprofilschiene übertragen. Sowohl ein Aufsetzen und Einschwenken von der Stirnseite oder von der Rückseite der Modulbrücke, als aber auch ein direktes lineares Aufsetzen und Fügen der Modulbrücke auf der Tragprofilschiene sind möglich.

In einer weiteren vorteilhaften Ausführungsform des Komponentenaufbausystems umfasst das Brückenmodul einen Zentrierabschnitt zum Zentrieren des Brückenmoduls auf der Tragprofilschiene. Dadurch wird beispielsweise der technische Vorteil erreicht, dass das Brückenmodul in einfacher Weise in der vorgesehenen Position aufgesetzt werden kann und durch den Zentrierabschnitt zusätzlich an der Tragprofilschiene stabilisiert wird.

In einer weiteren vorteilhaften Ausführungsform des Komponentenaufbausystems umfasst die Modulrasteinrichtung eine Tasche zum Einsetzen eines Werkzeugs, um die Modulrasteinrichtung aufzubiegen. Dadurch wird beispielsweise der technische Vorteil erreicht, dass das Brückenmodul auf einfache Weise von der Tragprofilschiene abgenommen werden kann.

In einer weiteren vorteilhaften Ausführungsform des Komponentenaufbausystems liegt die Tasche an dem Rastabschnitt der Rastnase gegenüber. Dadurch wird beispielsweise der technische Vorteil erreicht, dass sich die auf die Tasche ausgeübte Kraft direkt auf die Rastnase überträgt und das Brückenmodul mit geringem Aufwand abnehmbar ist.

In einer weiteren vorteilhaften Ausführungsform des Komponentenaufbausystems wird die Tasche durch einen Balkonabschnitt gebildet, der aus dem Rastabschnitt herausragt. Dadurch wird beispielsweise der technische Vorteil erreicht, dass die Tasche einstückig in stabiler Weise durch den Balkonabschnitt gebildet wird.

In einer weiteren vorteilhaften Ausführungsform des Komponentenaufbausystems wird das unbeabsichtigte Öffnen, Aufbiegen und Lösen der Modulrasteinrichtung im montierten Zustand mit der Funktionskomponente durch ein blockierendes Übergreifen eines Gehäuses der Funktionskomponente verhindert.

In einer weiteren vorteilhaften Ausführungsform des Komponentenaufbausystems umfasst das Brückenmodul eine Schwalbenschwanzaussparung zum seitlichen Fixieren des Brückenmoduls an einem Klemmblock. Dadurch wird beispielsweise der technische Vorteil erreicht, dass das Brückenmodul auf einfache Weise seitlich fixiert werden kann.

In einer weiteren vorteilhaften Ausführungsform des Komponentenaufbausystems umfasst das Brückenmodul eine Arretierungseinrichtung zum unverschiebbaren Arretieren des Brückenmoduls auf der Tragprofilschiene. Dadurch wird beispielsweise der technische Vorteil erreicht, dass die Festigkeit eines Verbundes von Elementen auf der Tragprofilschiene erhöht wird.

In einer weiteren vorteilhaften Ausführungsform des Komponentenaufbausystems umfasst das Komponentenaufbausystem eine Funktionskomponente, wobei die Funktionskomponente ein Funktionskomponentenunterteil, das auf das Brückenmodul aufsetzbar ist, und ein auf das Funktionskomponentenunterteil aufsetzbares Funktionskomponentenoberteil umfasst, und wobei das Komponentenaufbausystem über das Brückenmodul mit einer zweiten Funktionskomponente seitlich erweiterbar ist.

In einer weiteren vorteilhaften Ausführungsform des Komponentenaufbausystems bildet das Funktionskomponentenoberteil eine Verbindungsschnittstelle für das Funktionskomponentenunterteil und eine weitere Verbindungsschnittstelle für ein auf das Funktionskomponentenoberteil aufsetzbares weiteres Funktionskomponentenoberteil.

In einer weiteren vorteilhaften Ausführungsform des Komponentenaufbausystems umfasst das Funktionskomponentenunterteil eine Komponentenbefestigungseinrichtung zum Halten der Funktionskomponente auf der Tragprofilschiene.

In einer weiteren vorteilhaften Ausführungsform des Komponentenaufbausystems sind das Brückenmodul und/oder die Funktionskomponente (400) auf oder entlang der Tragprofilschiene verschiebbar sind.

In einer weiteren vorteilhaften Ausführungsform des Komponentenaufbausystems sind das Funktionskomponentenunterteil und das Brückenmodul mittels einer formschlüssigen Verbindung verbindbar, um die auf die Verbindung zwischen dem Brückenmodul und dem Funktionskomponentenunterteil wirkenden Zugkräfte entlang der Tragprofilschiene aufzunehmen.

In einer weiteren vorteilhaften Ausführungsform des Komponentenaufbausystems umfasst das Brückenmodul eine Schwalbenschwanzaussparung zum seitlichen Fixieren des Brückenmoduls an einem Klemmblock umfasst.

In einer weiteren vorteilhaften Ausführungsform des Komponentenaufbausystems umfasst das Komponentenaufbausystem einen Klemmblock zum Festsetzen des Brückenmoduls gegen die Verschiebbarkeit auf der Tragprofilschiene, wobei der Klemmblock mit dem Brückenmodul verbindbar ist.

In einer weiteren vorteilhaften Ausführungsform des Komponentenaufbausystems ist der Klemmblock mit dem Brückenmodul kraftschlüssig oder formschlüssig, insbesondere mittels einer T-Nut/Feder-Verbindung oder einer Schwalbenschwanzverbindung oder einer Schraubverbindung oder einer Klemmverbindung, verbindbar.

In einer weiteren vorteilhaften Ausführungsform des Komponentenaufbausystems ist der Klemmblock ausgebildet ist, die Tragprofilschiene formschlüssig zu umgreifen und/oder kraftschlüssig zu klemmen.

In einer weiteren vorteilhaften Ausführungsform des Komponentenaufbausystems umfasst der Klemmblock eine nach außen geführte Erdungsklemme, welche mit der Tragprofilschiene elektrisch leitend verbindbar ist.

Weitere Ausführungsbeispiele der Erfindung sind in den Zeichnungen dargestellt und werden im Folgenden näher beschrieben. Es zeigen:
- Fig. 1: eine Querschnittsansicht eines Komponentenaufbausystems;
- Fig. 2: eine Aufsicht auf das Komponentenaufbausystem;
- Fig. 3: eine perspektivische Ansicht auf eine Tragprofilschiene mit einem Brückenmodul;
- Fig. 4: eine weitere perspektivische Ansicht auf die Tragprofilschiene mit mehreren Brückenmodulen;
- Fig. 5: eine Aufsicht auf die Tragprofilschiene mit mehreren Brückenmodulen;
- Fig. 6: eine perspektivische Ansicht eines Brückenmoduls;
- Fig. 7: eine perspektivische Ansicht mehrerer Brückenstecker;
- Fig. 8: eine Seitenansicht des Brückenmoduls auf der Tragprofilschiene,
- Fig. 9: eine perspektivische Ansicht eines weiteren Brückenmoduls;
- Fig.10: eine perspektivische Ansicht eines weiteren Brückenmoduls;
- Fig.11: eine perspektivische Ansicht eines Klemmblocks;
- Fig. 12: unterschiedliche Ansichten eines Loslager-Endbrückenmoduls;
- Fig. 13: eine Ansicht eines Loslager-Endbrückenmoduls in Verbindung mit den übrigen Feldbuskomponenten;
- Fig. 14: unterschiedliche Ansichten eines Festlager-Erdungsmodul;
- Fig. 15: vergrößerte Ansichten einer Verbindung mit dem Brückenmodul; und
- Fig. 16: eine Explosionsdarstellung des Komponentenaufbausystems.

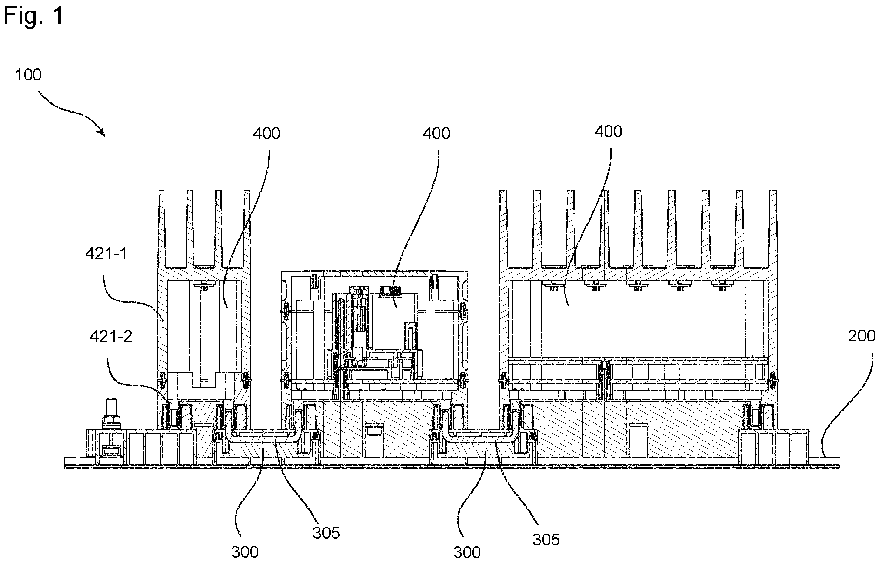

Fig. 1 zeigt eine Querschnittsansicht eines Komponentenaufbausystems 100. Das Komponentenaufbausystem 100 ist aus einem zusammensteckbaren Gehäusebaukasten zusammengesetzt, bei dem die Komponenten auf eine Tragprofilschiene 200 aufgerastet werden. Das Aufbaukonzept des Komponentenaufbausystems 100 umfasst eine Tragprofilschiene 200 als Montageplattform, Brückenmodule 300 und Funktionskomponenten 400, die jeweils aus einem Verbindungsunterteil und einem Funktionsoberteil bestehen.

Je nach Anwendungszweck können unterschiedliche Ausführungen des Aufbaukonzeptes realisiert werden. Das Aufbaukonzept ist endlos erweiterbar. Die internen elektrischen Verbindungen für Energieverteilung von beispielsweise 400V oder 24V und der Datenbus werden gleichzeitig mit dem Zusammenstecken der Komponenten realisiert. Die Verbindungsfunktionen werden im Funktionskomponentenunterteil 421-2 der Funktionskomponenten 400 und den Brückenmodulen 300 mit den Brückensteckern 305 realisiert. Die Funktionen Versorgen, Schützen, Schalten ergeben sich aus der Reihenfolge der Anordnung der Funktionskomponenten 400. Die Anwenderfunktionen, wie beispielsweise Versorgen, Schützen oder Schalten, sind im Funktionskomponentenoberteil 421-1 realisiert, das über Steckkontakte mit dem Funktionskomponentenunterteil 421-2 verbunden ist.

Das Funktionskomponentenoberteil 421-1 hat eine definierte mechanische und elektrische Schnittstelle zum Funktionskomponentenunterteil 421-2 und kann auch auf anderen Funktionskomponentenunterteilen 421-2 mit gleicher Schnittstelle verwendet werden. Das Funktionskomponentenunterteil 421-2 enthält lediglich die Verbindungstechnik. Das Funktionskomponentenoberteil 421-1 enthält beispielsweise die Funktionen Trennen, Schützen oder Schalten. Die Wirkungsrichtung der vorgenannten Funktionen erfolgt je nach Funktionskomponentenoberteil 421-1 und Funktionskomponentenunterteil 421-2 in der Linie und/ oder in den Verbraucherabgang, d.h. einer Steckverbindung in Funktionskomponentenoberteil 421-1. Die Verbindungstechnik kann im Funktionskomponentenunterteil 421-2 unterbrochen sein.

Die Tragprofilschiene 200 bildet ein einteiliges Trägersystem mit einer breiten Schiene für einen Rack-Aufbau, die die Geometrie der Auflagekanten des Brückenmoduls 300 und der Funktionskomponenten 400 nachbildet. Alternativ können zwei getrennte Standard-Tragprofilschienen als zweiteiliges Trägersystem, beispielsweise mit einer Breite von 35 mm, für einen Wandaufbau verwendet werden. Das Tragprofil kann durch ein Hutprofil gebildet werden.

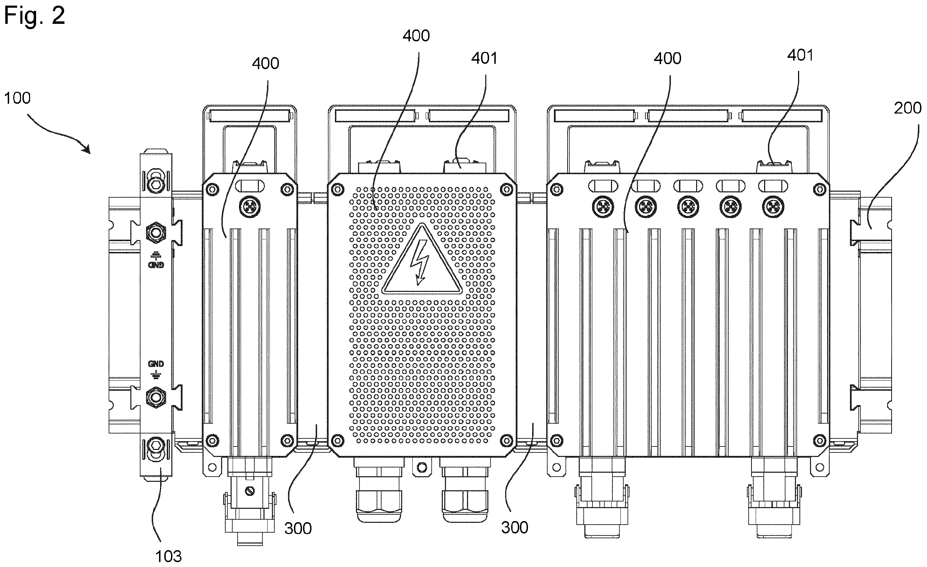

Fig. 2 zeigt eine Aufsicht auf das Komponentenaufbausystem 100. Als elektrische Verbindung für eine Energieverteilung und den Datenbus werden auf den Tragprofilschienen 200 aufrastbare Brückenmodule 300 mit nach vorne gerichteten Brückensteckern 305 aufgerastet. Die Aufsteckrichtung auf die Brückenmodule steht senkrecht zur Ebene, die die Tragprofilschienen 200 aufspannen. Die Funktionskomponenten 400 umfassen jeweils ein oder mehrere Komponentenbefestigungseinrichtungen 401 zum Befestigen der Funktionskomponente 400 an der Tragprofilschiene 200. An der linken Seite des Verbundes befindet sich ein Klemmblock 103.

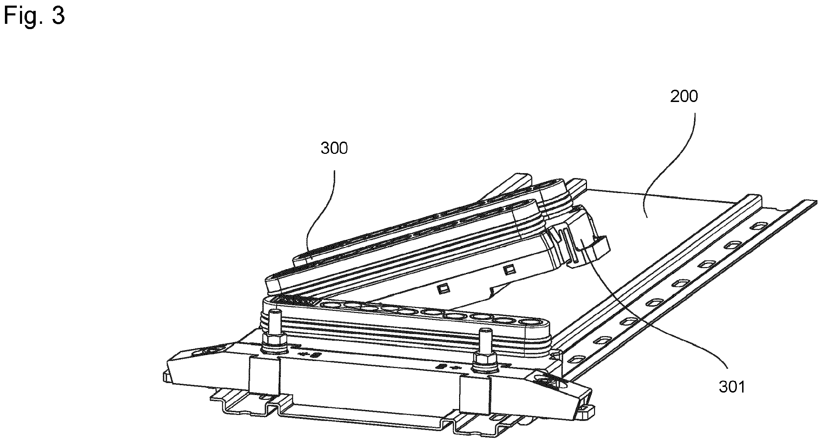

Fig. 3 zeigt eine perspektivische Ansicht auf eine Tragprofilschiene 200 mit dem Brückenmodul 300. Das Brückenmodul 300 umfasst die Steckkontakte und eine Modulrasteinrichtung 301 zum Aufrasten des Brückenmoduls 300 auf die Tragprofilschiene 200 beim Aufsetzen des Brückenmoduls 300. Die Brückenmodule 300 sind nach den Aufrasten frei entlang der Tragprofilschiene 200 verschiebbar.

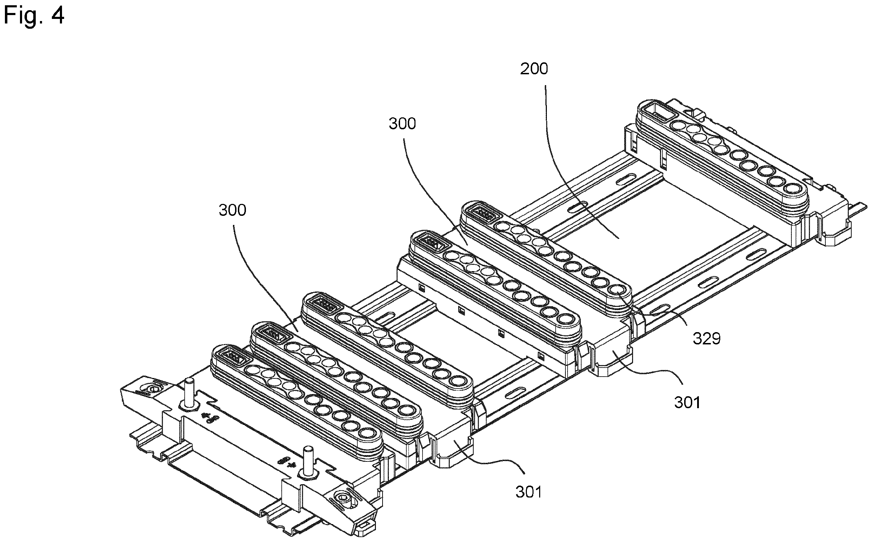

Fig. 4 zeigt eine weitere perspektivische Ansicht auf die Tragprofilschiene 200 mit mehreren Brückenmodulen 300. Die Brückenmodule 300 können in unterschiedlichen Breiten ausgeführt sein, so dass der Abstand zwischen gefügten Funktionskomponenten 400 durch die Brückenmodule 300 bestimmt wird. Dieser Abstand definiert einen Lüftungskamin zwischen den Funktionskomponenten 400, die beispielsweise ein metallisches Funktionskomponentenoberteil 421-1 als Kühlkörper umfassen. Der entstehende Luftkanal dient zur seitlichen Entwärmung der Funktionskomponenten 400. Zudem kann ein Freiraum zwischen den Funktionskomponenten 400 für eine senkrecht durchgeführte Verkabelung im unteren Gehäusebereich verwendet werden, da sich dort kein Kühlkörper befindet.

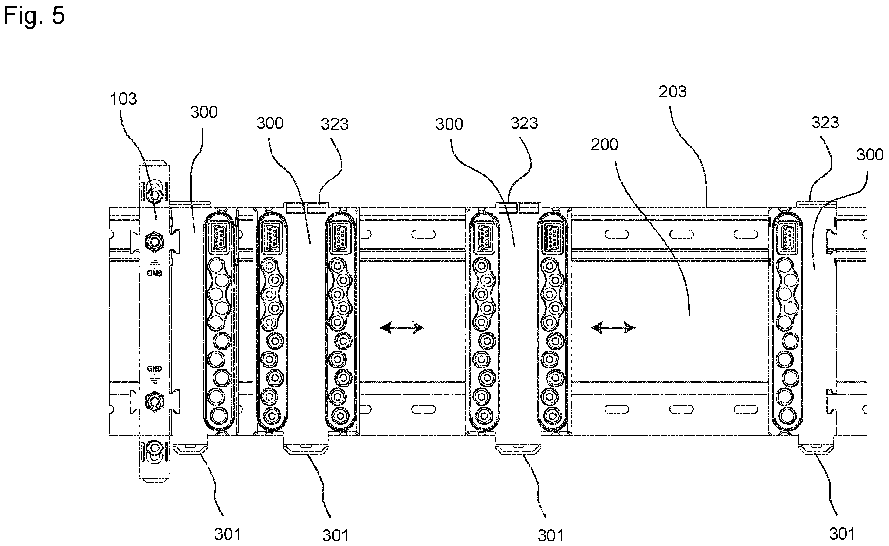

Fig. 5 zeigt eine Aufsicht auf die Tragprofilschiene 200 mit mehreren Brückenmodulen 300. Die Tragprofilschiene 200 umfasst eine Unterkante und eine Oberkante 203. Die Brückenmodule 300 sind im aufgerasteten Zustand in Pfeilrichtung seitlich verschiebbar. Durch die freie Verschiebbarkeit der Brückenmodule 300 ist ein rasterfreier Aufbau auf der Tragprofilschiene 200 möglich, aber nicht zwingend. Nach dem Aufrasten ist das Brückenmodul 300 beliebig auf der Tragprofilschiene 200 verschiebbar und kann zur Anpassung an beliebige Gehäusebreiten der Funktionskomponenten 400 verwendet werden. Dadurch wird ein Muss-Raster vermieden.

Ist ein linkes Brückenmodul 300 montiert, führt bei der Montage eine linke Hand die Funktionseinheit bündig an das linke Brückenmodul 300. Die rechte Hand schiebt das rechte Brückenmodul 300 auf Anschlag an die Basis des Funktionsgehäuses der Funktionskomponente 400. Danach steckt die linke Hand die Funktionskomponente 400 auf die beiden Steckgesichter des Brückenmoduls 300. Die mechanische Positionierung der Funktionskomponenten 400 in der Feldstation ist grundsätzlich beliebig. Die Anordnung und Abfolge in der Linie ist funktionsbestimmend.

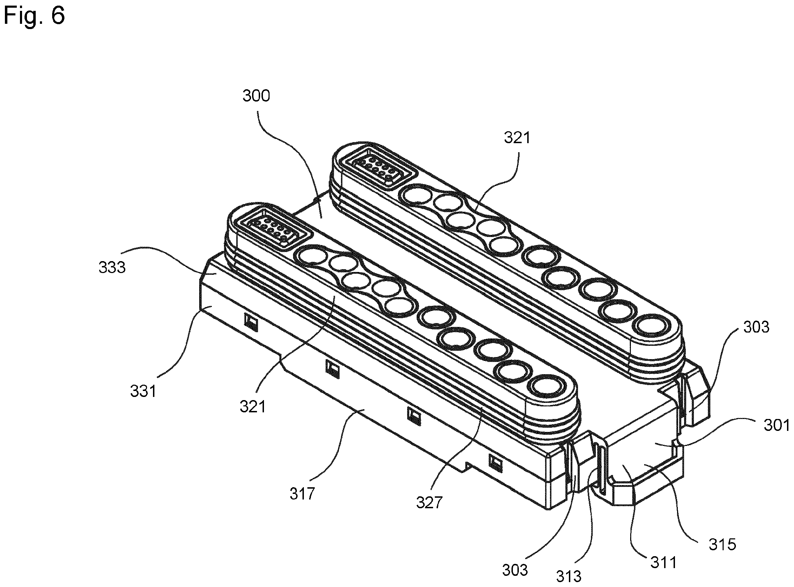

Fig. 6 zeigt eine perspektivische Ansicht eines Brückenmoduls 300. Das Brückenmodul 300 dient für Vormontage durch Aufrasten auf der Tragprofilschiene 200 und zum elektrischen Verbinden von Funktionskomponenten 400 des Komponentenaufbausystems 100. Das Brückenmodul 300 kann in unterschiedlichen Breiten gefertigt sein, so dass eine gezielte Beabstandung aufgebrachter Funktionsmodule 400 erreicht wird. Das Brückenmodul 300 kann beispielsweise eine Breite von 70 mm aufweisen, so dass im Zusammenspiel mit den Funktionskomponenten 400 ein Luftkanal mit einer Breite von 20 mm entsteht.

Das Brückenmodul 300 umfasst ein Funktionskomponentenunterteil 331, ein Funktionskomponentenoberteil 333 und nicht gezeigte Gehäusedichtungen sowie eine Dichtung 327, beispielsweise im Feld mit Dichtung oder im Schaltschrank ohne Dichtung. Eine Gehäuseverbindung erfolgt durch Rasten, Schrauben, Verpressen, Schweißen, Kleben. Der elektrische Aufbau der Brückenmodule 300 stellt Verbindungen für Klein- und Niederspannungen bereit. Dazu sind im Inneren des Brückenmoduls 300 Leitern oder Steckern aus gebogenem Runddraht oder als Stanzumformteile oder als Stromschienen aus gestanztem Blech mit aufkontaktierten Steckerpins und für eine Datenbusverbindung Stecker auf passiver oder aktiver Platine vorgesehen. Die Brückenmodule 300 mit verschiedenen Steckerbeabstandungen bereitgestellt sein, um zwischen den Funktions-komponenten bestimmte Freiräume zu erzeugen.

An der Vorderseite umfasst das Brückenmodul 300 zwei hervortretende Steckabschnitte 321, die die Steckgesichter bilden. Auf die Steckabschnitte 321 wird jeweils eine rechte und eine linke Funktionskomponente 400 aufgesetzt. Die Steckabschnitte 321 umfassen eine umlaufende Dichtung 327, so dass ein Dichtungssystem zur aufgesteckten Funktionskomponente entsteht.

An den Querseiten umfasst das Brückenmodul 300 jeweils zwei Aufnahmenuten 303 zum Einsetzen eines Einsatzabschnittes einer rechtseitigen oder linksseiteigen Funktionskomponente 400, um Zugkräfte der Funktionskomponente 400 entlang der Tragprofilschiene 200 aufzunehmen. Durch den Einsatzabschnitt der Funktionskomponente 400 und der Aufnahmenut 303 wird eine formschlüssige Verbindung zwischen der Funktionskomponente 400 und dem Brückenmodul 300 hergestellt. Dadurch kann eine Beschädigung der Steckabschnitte 321 durch Zugkräfte verhindert werden.

Zur mechanischen Entkopplung der schwimmend gelagerten elektrischen Steckverbindungen der Brückenmodule 300 und der Funktionskomponenten 400 findet eine übergeordnete mechanische Vorzentrierung statt. Dies geschieht durch das mechanische Eingreifen einer oberhalb und unterhalb der Steckereinheit in der Funktionskomponente 400 angeordneten Rippe, die in die entsprechende Aufnahmenut 303 im Brückenmodul 300 eingreift und in der Endlage in x- und y-Richtung jeweils anliegend ist.

Dadurch werden Kräfte, die in x- und in y-Richtung auf die elektrische Steckverbindung einwirken, mechanisch entkoppelt. Abziehkräfte der Funktionskomponenten 400 in z-Richtung werden entkoppelt durch geeignete Rastschieber, die sich in den Funktionskomponenten befinden und hinter der Tragprofilschiene eingreifen. Somit sind im montierten Zustand alle möglichen Freiheitsgrade zwischen Brückenmodulen 300 und Funktionskomponenten 400 mechanisch blockiert.

Daneben umfasst das Brückenmodul 300 an einer der Querseiten eine Modulrasteinrichtung 301 zum Aufrasten des Brückenmoduls 300 auf die Tragprofilschiene 200. Die Modulrasteinrichtung 301 wird durch einen elastischen Rastabschnitt 311 gebildet, der nach dem Aufsetzen des Brückenmoduls 300 die Tragprofilschiene 200 seitlich übergreift. Der Rastabschnitt 311 umfasst eine längliche Ausnehmung 313 entlang des Rastabschnittes 311, so dass die Biegsamkeit des Rastabschnittes 311 erhöht wird. Dadurch kann das Brückenmodul 300 einstückig aus einem festen Kunststoff gebildet werden, ohne dass der Rastabschnitt 311 eine zu hohe Festigkeit aufweist.

Am Ende des Rastabschnittes 311 ist ein hervorspringender Balkonabschnitt als Tasche 315 gebildet. Die Tasche 315 dient zum Einsetzen eines Werkzeuges, wie beispielsweise einem Schraubendreher. Durch seitliches Kippen des Werkzeuges kann der Rastabschnitt 311 nach außen gebogen werden, so dass sich das Brückenmodul 300 von der Tragprofilschiene 200 lösen lässt.

An der Rückseite des Brückenmoduls 300 befindet sich ein hervorspringender Zentrierabschnitt 317, der das Brückenmodul 300 zusätzlich an der Tragprofilschiene 200 stabilisiert und abstützt. Zu diesem Zweck liegen die obere und untere Seite des Zentrierabschnittes 317 jeweils an dem oberen oder unteren Tragprofil der Tragprofilschiene 200 an.

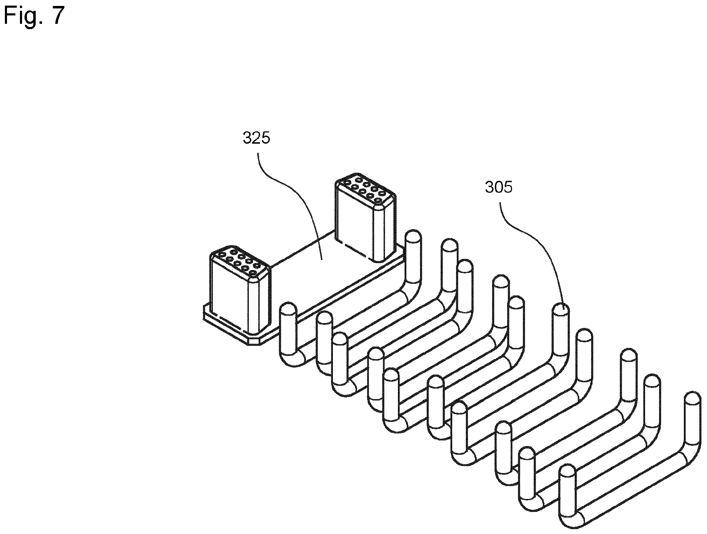

Fig. 7 zeigt eine perspektivische Ansicht mehrerer Brückenstecker 305 und 325. Die Brückenstecker 305 werden durch U-förmige Rundleiter gebildet, die die elektrischen Spannungen und Ströme von einer Funktionskomponente 400 an die andere Funktionskomponente 400 weitergeben. Durch die Rundleiter kann beispielsweise ein sich selbst aufbauender Verbindungsbus für Spannungen von 400 V und 2 x 24V gebildet werden.

Der Brückenstecker 325 umfasst mehrere elektrische Verbindungen zum parallelen oder seriellen Übertragen von Datensignalen zwischen den Funktionskomponenten 400. Dadurch kann ein Datenbus zwischen den Funktionskomponenten 400 realisiert werden. Die Brückenstecker 305 und 325 werden von dem Brückenmodul 300 aufgenommen und bilden eine interne Verdrahtung. Der Brückenstecker 325 kann ausgetauscht werden, so dass ein Brückenmodul 300 mit auswechselbarer Baugruppe für unterschiedliche Datenbus-Varianten entsteht.

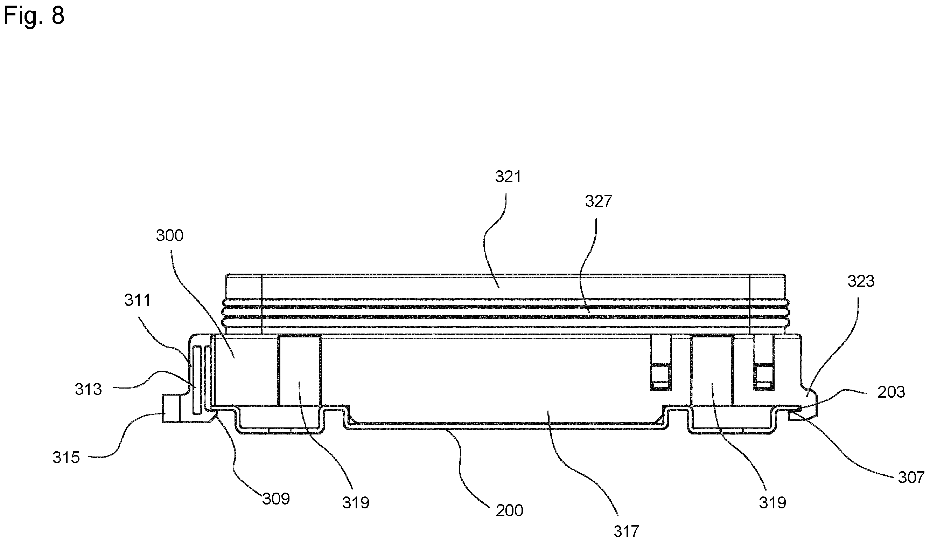

Fig. 8 zeigt eine Seitenansicht des Brückenmoduls 300 auf der Tragprofilschiene 200. Der Zentrierabschnitt 317 befindet sich zwischen beiden Tragprofilen der Tragprofilschiene 200. Der Rastabschnitt 311 ist einstückig seitlich an dem Brückenmodul 300 ausgebildet. Am Ende des Rastabschnittes 311 befindet sich eine Rastnase 309, die nach dem Aufsetzen des Brückenmoduls 300 die Tragprofilschiene 200 hintergreift, welche beispielsweise ein Rasthaken sein kann.

An der gegenüberliegenden Seite befindet sich eine Schienenaussparung 307 zum Einsetzen einer Kante 203 der Tragprofilschiene 200. Die Schienenaussparung 307 ist innerhalb eines U-förmigen Aufsetzabschnittes 323 gebildet, der die Kante 203 der Tragprofilschiene 200 umgreift und einstückig an dem Brückenmodul 300 gebildet ist. Der Aufsetzabschnitt 323 ist an der Querseite des Brückenmoduls 300 angeordnet, die der Querseite gegenüberliegt, die die Modulrasteinrichtung 301 umfasst. An der Längsseite des Brückenmoduls 300 befinden sich zwei Schwalbenschwanzaussparung 319 zum seitlichen Fixieren des Brückenmoduls 300 an dem Klemmblock 103.

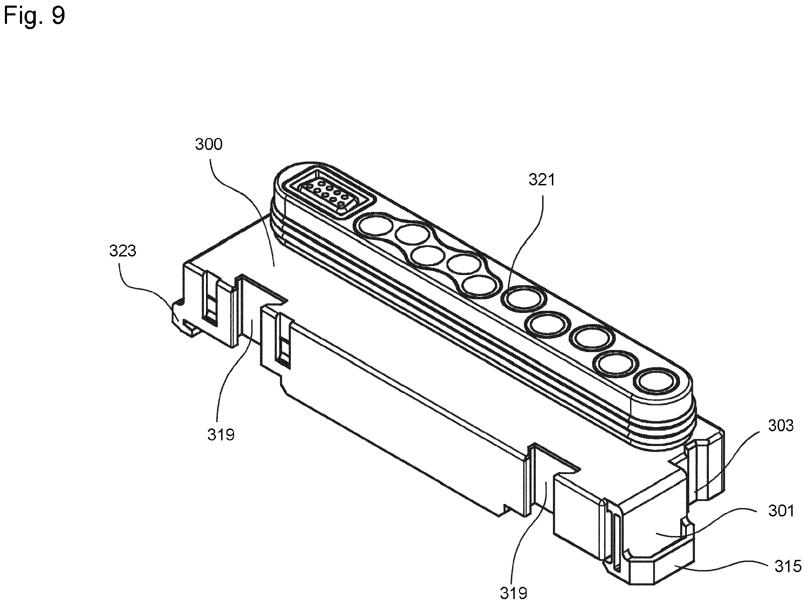

Fig. 9 zeigt eine perspektivische Ansicht eines weiteren Brückenmoduls 300. Das Brückenmodul 300 umfasst die beiden Schwalbenschwanzaussparungen 319 zur linksseiteigen Befestigung des Brückenmoduls 300 an einem Klemmblock 103. Das Brückenmodul 300 bildet ein Anfangsmodul zur rechtsseitigen Erweiterung des Komponentenaufbausystems 100 durch Aufstecken einer Funktionskomponente 400 und weist lediglich einen Steckabschnitt 321 auf. An diesem Brückenmodul 300 ist ebenfalls eine Modulrasteinrichtung 301 und eine Aufnahmenut 303 an jeder Querseite vorgesehen.

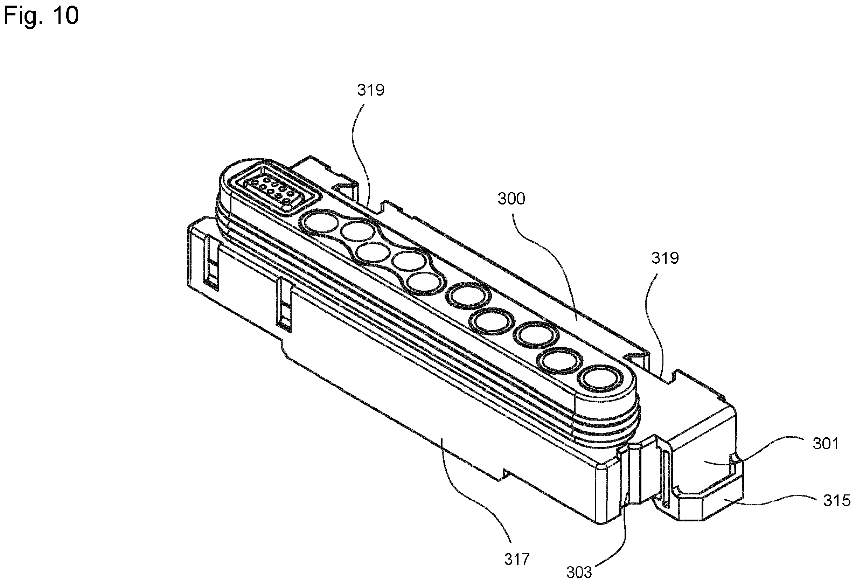

Fig. 10 zeigt eine perspektivische Ansicht eines weiteren Brückenmoduls 300. Das Brückenmodul 300 umfasst ebenfalls die beiden Schwalbenschwanzaussparungen 319 zur rechtsseitigen Befestigung des Brückenmoduls 300 an dem Klemmblock 103. Das Brückenmodul 300 bildet ein Endmodul zum Terminieren des selbst aufbauenden Feldbusses und weist ebenfalls lediglich einen Steckabschnitt 321 auf. An diesem Brückenmodul 300 ist ebenfalls eine Modulrasteinrichtung 301 eine Aufnahmenut 303 an jeder Querseite vorgesehen.

Alternativ kann der Busabschluss durch ein reguläres Brückenmodul 300 mit zwei Steckabschnitten 321 gebildet werden, auf dessen ungenutzten Steckabschnitt 321 eine Kappe als aufsteckbarer Berührschutz gesteckt ist.

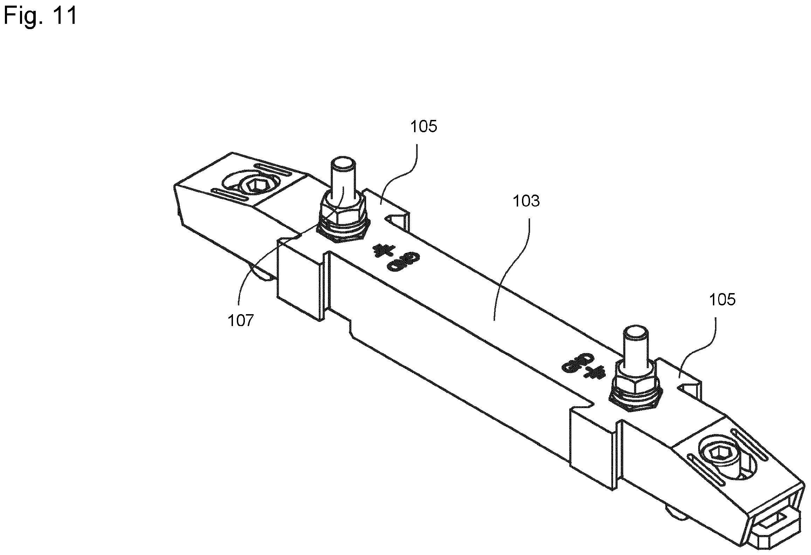

Fig. 11 zeigt eine perspektivische Ansicht des Klemmblocks 103 mit zwei Erdungsklemmen 107. Der Klemmblock 103 wird auf der Tragprofilschiene 200 verschraubt und ist unverrückbar. Der Klemmblock 103 umfasst vier Schwalbenschanzabschnitte 105, von denen jeweils zwei rechtsseitig oder linksseitig in die Schwalbenschwanzaussparungen 319 der Brückenmodule 300 einsetzbar sind. Dadurch wird das Anfangsmodul oder das Endmodul in seiner Lage auf der Tragprofilschiene 200 fixiert.

Das Brückenmodul 300 ist das Schlüsselverbindungselement im Gehäuseaufbaukonzept des Komponentenaufbausystems 100, welches sowohl die elektrischen Verbindungen zwischen den Funktionskomponenten 400 übernimmt, als auch zusammen mit der Tragprofilschiene 200 die Verbindung zur klassischen Aufbautechnik bildet. Im Allgemeinen kann das Brückenmodul 300 als Loslager ausgebildet sein, dass lediglich rastend und verschiebbar an der Tragprofilschiene 200 befestigt ist oder als ein Festlager mit metallischer Klemmvorrichtung und PE-Kontaktierung.

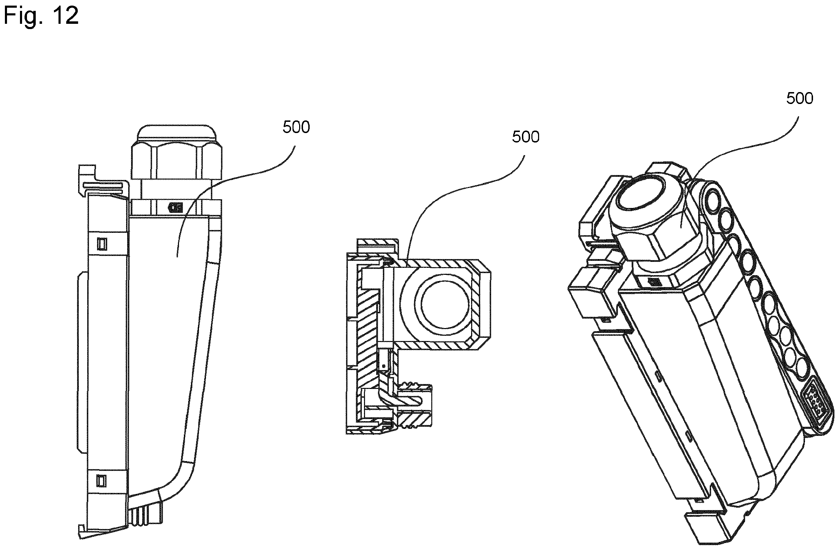

Fig. 12 zeigt unterschiedliche Ansichten eines Loslager-Endbrückenmoduls 500. Die Loslager-Endbrückenmodule 500 können in Rechtsausführung rechtsseitig oder in Linksausführung linksseitig verwendet werden. Zudem können die Loslager-Endbrückenmodule 500 optional durch die Verwendung von vorkonfektionierten Anschlussleitungen mit angecrimpten Steckerstiften als Energieeinspeisungen oder Energieabgänge verwendet werden. Ein Loslager-Zwischenbrückenmodul kann in verschiedenen Breiten bereitgestellt werden.

Große Abstände der Funktionskomponenten 400 dienen zur zusätzlichen seitlichen Umströmung der Funktionskomponenten 400 zur Verbesserung der Kühlung und erzeugen Platz für Leitungsdurch und -zuführungen sowie verbesserte Zugänglichkeit bei hoher Leitungsdichte. Kleinere Abstände der Funktionskomponenten 400 erzeugen eine Verdichtung der Gesamtsystemabmessungen und eine insgesamt kompaktere Ausführung.

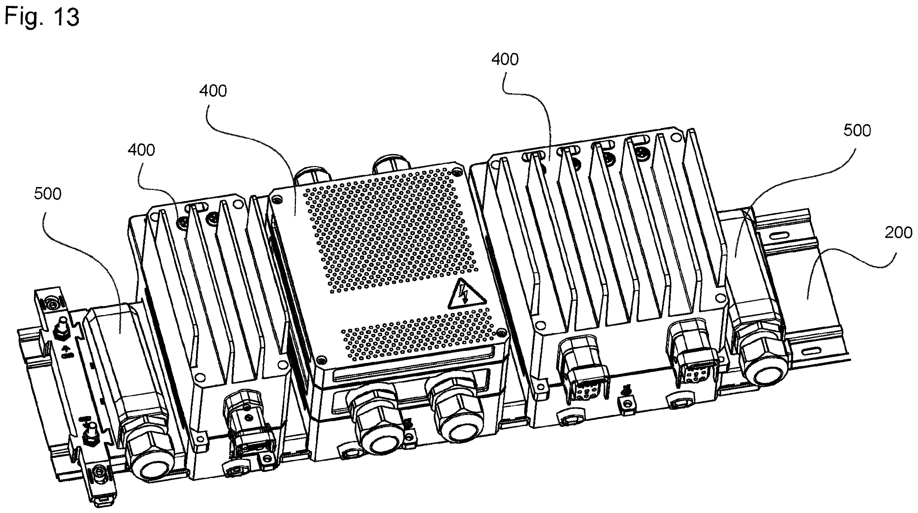

Fig. 13 zeigt eine Ansicht eines Loslager-Endbrückenmoduls 500 in Verbindung mit den übrigen Feldbuskomponenten 400. Ein Brückensteckeranfang/-Ende des Loslagers 500 dient zum links- und rechtsseitigen Abschluss des selbstaufbauenden Verbindungsbus mit aufsteckbarem Busabschluss. Das Brückenmodul 300 kann als Loslager rastend verschiebbar oder als Festlager mit Metall-Klemmvorrichtung und PE-Kontaktierung vorgesehen sein

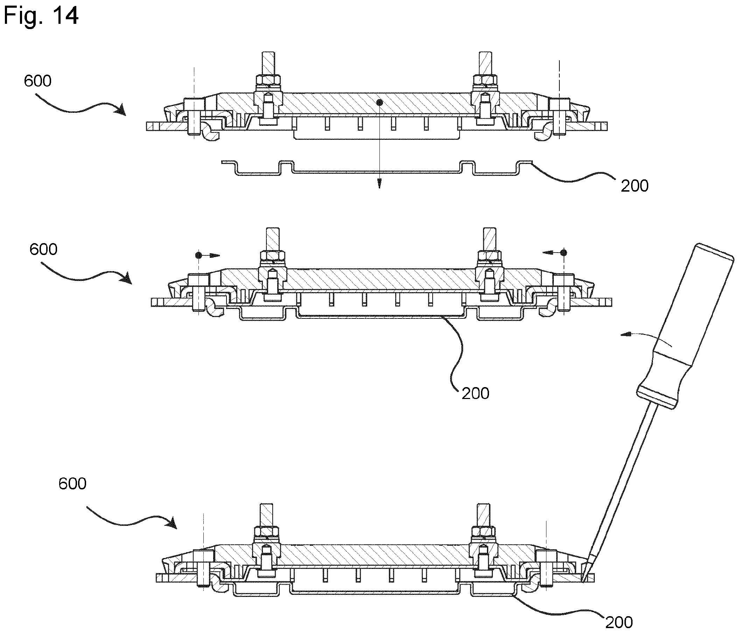

Fig. 14 zeigt ein Festlager-Erdungsmodul 600. Ein mechanisches Festsetzen des gesamten Systemaufbaues entlang der Tragprofilschiene 200, der durch die Verschiebbarkeit der Brückenmodule 300 auf der Tragprofilschiene 200 selbst entsteht, geschieht durch die Verwendung des rechts- oder linksseitig angeordneten Festlager-Erdungsmodules 600.

Das Festlager-Erdungsmodul 600 setzt das Gesamtsystem in x-Richtung an einem Fixpunkt auf der Tragprofilschiene 200 fest. Durch diese Anordnung ist, von einem Fixpunkt aus, ein freies Atmen des Systemaufbaues in x-Richtung möglich, wie beispielsweise bei wärmebedingtem Längenwachstum. Die mechanische Klemmung dieses Fixpunktes ist zugleich die zentrale elektrische Erdung und Verbindung mit der Tragprofilschiene des Systemaufbaus.

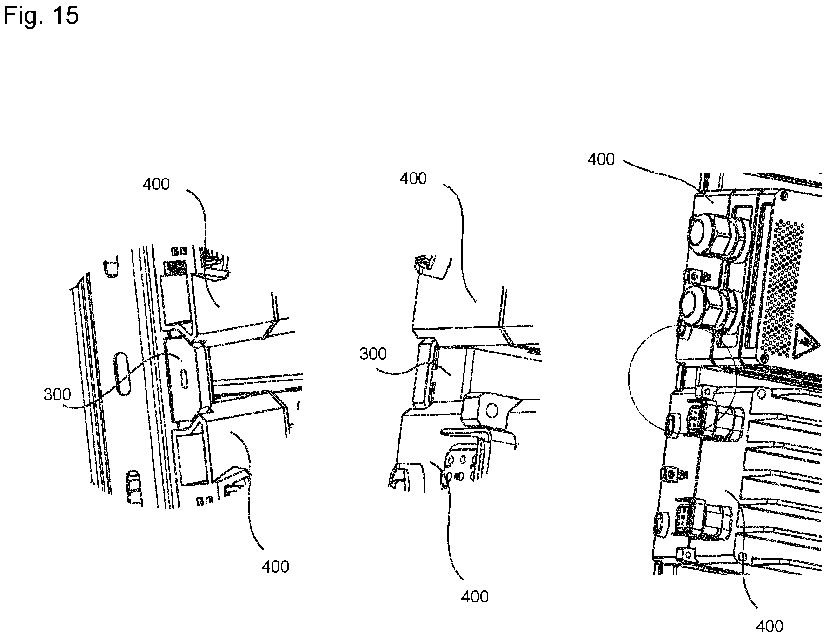

Fig. 15 zeigt vergrößerte Ansichten einer Verbindung mit dem Brückenmodul 300. Die technisch richtige Montage- und Demontagereihenfolge, d.h. erst Brückenmodul 300, dann Funktionskomponente 400 und bei Demontage umgekehrt, wird durch die mechanische Ausgestaltung der Brückenmodule 300 und Funktionskomponenten 400 zwangsweise sichergestellt. Auch im montierten Zustand sind die Funktionseinrichtungen sichtbar und dadurch selbsterklärend.

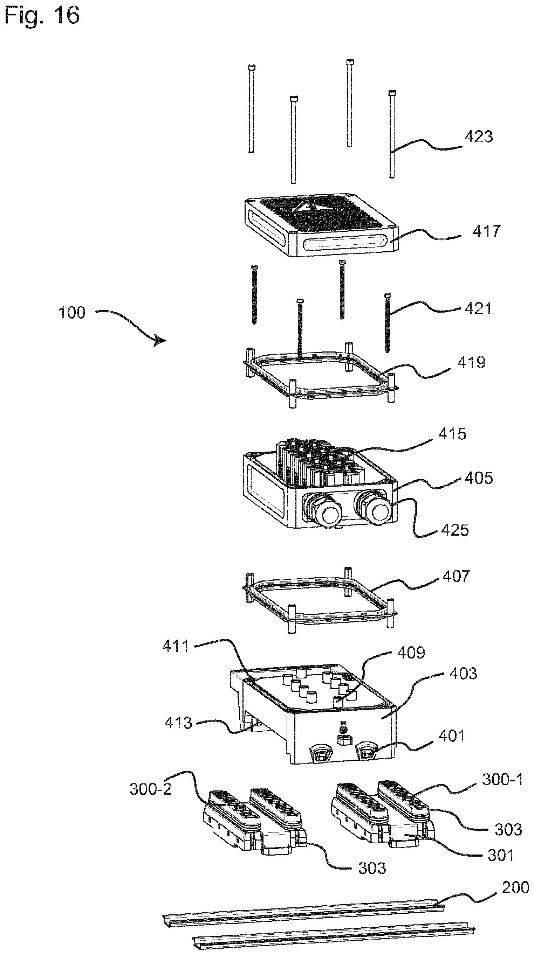

Fig. 16 zeigt eine Explosionsansicht des Komponentenaufbausystems 100. Die Brückenmodule 300-1 und 300-2 sind auf die Tragprofilschiene 200 aufsetzbar und entlang der Tragprofilschiene 200 verschiebbar. Ein Funktionskomponentenunterteil 403 weist jeweils eine Anschlusseinrichtung zum elektrischen verbinden mit den linken Brückenmodule 300-2 und dem rechten Brückenmodul 300-2 auf. Die Anschlusseinrichtungen werden beispielsweise durch Steckbuchsen gebildet, in die die vorstehenden Kontaktabschnitte 307 der Brückenmodule 300-1 und 300-2 einsetzbar sind. Das Funktionskomponentenunterteil 403 ermöglicht eine Erweiterungsoption mit elektronischen Funktionen, durch die Bildung einer Schnittstelle elektrisch und mechanisch nach oben. Über die Brückenmodule 300 sind die Schnittstellen elektrisch und mechanisch nach links und/oder nach rechts in beliebiger Länge anreihbar.

Das Funktionskomponentenunterteil 403 und das Brückenmodul 300-1 bzw. 300-2 sind jeweils mittels einer formschlüssigen Verbindung, beispielsweise einer Feder-NutVerbindung, verbindbar. Das Funktionskomponentenunterteil 403 umfasst an der Unterseite beispielsweise einen vorstehenden Einsatzabschnitt 413, beispielsweise eine Feder, zum Einsetzen in eine Aufnahmenut 303 des jeweiligen Brückenmoduls 300-1 und 300-2, um Zugkräfte des Funktionskomponentenunterteils 403 entlang einer Tragprofilschiene 200 aufzunehmen. Das Funktionskomponentenunterteil 403 der Funktionskomponente 400 wird auf der Tragprofilschiene 200 mittels einer Komponentenbefestigungseinrichtung 401, beispielsweise einer Rastverbindung, befestigt.

An der Oberseite des Funktionskomponentenunterteils 403 ist eine umlaufende Aussparung 411 gebildet, in die ein ringförmiges Dichtelement 407 einsetzbar ist. Das Dichtelement 407 dichtet den Spalt zwischen dem Funktionskomponentenunterteil 403 und dem Funktionskomponentenoberteil 405 ab. Je nach Dichtelement 407 können unterschiedliche Schutzarten von IP20 bis IP6x realisiert werden. Zusätzlich sind an der Oberseite des Funktionskomponentenunterteils 403 mehrere herausstehende Anschlussteckabschnitte 409 gebildet, die ein Steckgesicht bilden. Die Anschlussteckabschnitte 409 bilden eine Schnittstelle zum elektrischen und mechanischen Verbinden des Funktionskomponentenoberteils 405.

Im Inneren eines Funktionskomponentenoberteils 405 befindet sich ein Kontaktblock 415 mit mehreren Klemmen zum Anschließen einzelner elektrischer Leiter, so dass das Funktionskomponentenoberteil 405 eine Verteilerfunktion aufweist. Das Funktionskomponentenoberteil 405 umfasst einen Deckel 417 ohne elektrische Anschlusseinheit, der zusammen mit dem Dichtelement 419 aufgesetzt wird. Das Dichtelement 419 wird mittels der vier Schrauben 421 an einem rahmenförmigen Gehäuseteil 425 des Funktionskomponentenoberteils 405 befestigt. Das Funktionskomponentenoberteil 405 wird mittels der Schrauben 423 mit dem Funktionskomponentenunterteil 403 verschraubt.

Durch das Funktionskomponentenunterteil 403 wird ein unbegrenztes Stapeln der Funktionskomponentenoberteile 403 ermöglicht. Insgesamt wird durch das Funktionskomponentenunterteil eine wiederholbare Kombination einer elektrischen Steckverbindung mit einem mechanischen Gehäuseaufbau erzielt.

Die Komponentenstationen können durch Verwendung einer einfachen Einspeisung als Endgeräte einer klassischen Sternverteilung genutzt werden oder durch Verwendung eines Anschluss- und Verteilermoduls (AV-Modul) zu Teilnehmern oder Knoten eines Energieverteilungsnetzwerks werden. Schalt- und Schutzorgane, Motorschalter, Buskoppler, oder I/Os, usw. können in freier, funktionsbestimmter Reihenfolge links und rechts des AV-Moduls angeordnet werden. Dadurch werden Vorteile beim Engineering durch eine sichtbare Trennung von Klein- und Niederspannungskomponenten erreicht. Mehrere Feldstationen können als Teilnehmer ein Netzwerk in beliebiger Struktur, wie beispielsweise Linie, Baum oder Ring, aufspannen.

Ein zentraler Schaltschrank innerhalb des ausgelegten Leistungsbereichs der Energieverteilung ist nicht mehr erforderlich. Durch eine geeignete Ausführung des mitgeführten Datenbusses können die Reihenfolge und die Positionen einzelner Komponenten der Feldstation vor der Inbetriebnahme auf die planungsgerechte Anordnung überprüft werden (Remote Putting into Service, Remote Service).

Das Komponentenaufbausystem 100 ermöglicht einen Aufbau von 'smarten' Installationsnetzwerken für Gleichstrom und Wechselstrom und schaltschranklose Verteilungen in geeigneten Anlagenlayouts. Das Komponentenaufbausystem kann in den Anwendungsgebieten Installation oder Energieverteilung verwendet werden. Bei einer verteilten Automatisierung ist ein Aufbau von modularen Feldstationen als Funktionsknoten in 'smarten' Installationsnetzwerken möglich. In alternativen Schaltschrank-Konzepten ist ein Aufbau von modularen Stationen im Schaltschrank ohne Stromschienen und ohne Steuerverdrahtung mit identischer Projektierung für IP20... IP6x möglich.

Durch das Komponentenaufbausystem 100 können modulare Motorschalter im Feld mit hoher Schutzart entwickelt werden. Durch das Komponentenaufbausystem 100 wird zusätzlich ein ganzheitliches Aufbaukonzept (Power & Drive, P&D) entwickelt, das die Aufgabe einer vorteilhaften Verteilung und Bereitstellung von Energie im Feld löst, beispielsweise außerhalb eines Schaltschranks.

Die Modularität des Komponentenaufbausystems 100 ermöglicht die Ausweitung der Anwendung über die modulare Feldstation hinaus zur 'smarten' Energieverteilung bis hin zu einem alternativen Schaltschrankaufbau. Zudem kann eine Abdeckung des Spektrums von Stand-Alone-Funktionskomponenten als Endgeräte an einer klassisch sternförmigen Energieverteilung erreicht werden. Das Komponentenaufbausystem 100 ermöglicht einen flexiblen Aufbau von modularen Systemen im Feld (IP6x) und innerhalb oder außerhalb eines Schaltschranks auf Standard-Tragprofilschienen (IP20). Bei einer Vormontage kann eine Vorverdrahtung auf einem Montagegestell erfolgen.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Komponentenaufbausystem
- 103: Klemmblock
- 105: Schwalbenschanzabschnitte
- 107: Erdungsklemmen

- 200: Tragprofilschiene
- 203: Kante

- 300: Brückenmodul
- 300-1: Brückenmodul
- 300-2: Brückenmodul
- 301: Modulrasteinrichtung
- 303: Aufnahmenut
- 305: Brückenstecker
- 307: Schienenaussparung
- 309: Rastnase
- 311: Rastabschnitt
- 313: Ausnehmung
- 315: Tasche
- 317: Zentrierabschnitt
- 319: Schwalbenschwanzaussparung
- 321: Steckabschnitt
- 323: Aufsetzabschnitt
- 325: Brückenstecker
- 327: Dichtung
- 329: Steckkontakt
- 331: Funktionskomponentenunterteil
- 333: Funktionskomponentenoberteil

- 400: Funktionskomponente
- 401: Komponentenbefestigungseinrichtung
- 403: Funktionskomponentenunterteil
- 405: Funktionskomponentenoberteil
- 407: Dichtelement
- 409: Anschlussteckabschnitte
- 411: Aussparung
- 413: Einsatzabschnitt
- 415: Kontaktblock
- 417: Deckel
- 419: Dichtelement
- 421: Schrauben
- 421-1: Funktionskomponentenoberteil
- 421-2: Funktionskomponentenunterteil
- 425: Gehäuseteil
- 500: Loslager-Endlosbrückenmodul
- 600: Festlager-Erdungsmodul

## Patentansprüche

1. Modulares Komponentenaufbausystem (100) mit einer Tragprofilschiene (200) und zumindest einem Brückenmodul (300) zum elektrischen Verbinden von zumindest einer Funktionskomponente (400), wobei das Brückenmodul (300) eine Modulrasteinrichtung (301) zum Aufrasten des Brückenmoduls (300) auf die Tragprofilschiene (200) umfasst
wobei das Brückenmodul (300) Brückenstecker umfasst, **dadurch gekennzeichnet, dass** das Brückenmodul (300) einen Zentrierabschnitt (317) zum Zentrieren des Brückenmoduls (300) auf der Tragprofilschiene (200) umfasst, wobei die Modulrasteinrichtung (301) einen elastischen Rastabschnitt (311) umfasst, welcher eine längliche Ausnehmung (313) umfasst, so dass die Biegsamkeit des Rastabschnittes (311) erhöht wird, wobei der Rastabschnitt (311) einstückig seitlich an dem Brückenmodul (300) ausgebildet ist, wobei der Zentrierabschnitt (317) aus der Rückseite des Brückenmoduls (300) hervorspringt und geeignet ist um zwischen beiden Tragprofilen der Tragprofilschiene (200) montiert zu werden, wobei das Brückenmodul (300) eine Schienenaussparung (307) aufweist, die eine Kante der Tragprofilschiene (200) umgreift und einstückig an dem Brückenmodul (300) gebildet ist.

2. Komponentenaufbausystem (100) nach Anspruch 1, wobei das Brückenmodul (300) eine Aufnahmenut (303) zum Einsetzen eines Einsatzabschnittes der Funktionskomponente (400) umfasst, um Zugkräfte der Funktionskomponente (400) entlang der Tragprofilschiene (200) aufzunehmen.

3. Komponentenaufbausystem (100) nach einem der vorstehenden Ansprüche, wobei die Modulrasteinrichtung (301) einen die Tragprofilschiene (200) umgreifenden starren Aufsetzabschnitt (323) und einen gegenüber dem starren Aufsetzabschnitt (323) angeordneten federelastischen Rastabschnitt (311) zum Aufrasten auf die Tragprofilschiene (200) umfasst.

4. Komponentenaufbausystem (100) nach einem der vorangehenden Ansprüche, wobei das Brückenmodul (300) eine Arretierungseinrichtung zum unverschiebbaren Arretieren des Brückenmoduls (300) auf der Tragprofilschiene (200) umfasst.

5. Komponentenaufbausystem (100) nach einem der vorangehenden Ansprüche, welche eine Funktionskomponente (400) umfasst, wobei die Funktionskomponente (400) ein Funktionskomponentenunterteil (403), das auf das Brückenmodul (300, 300-1) aufsetzbar ist, und ein auf das Funktionskomponentenunterteil (403) aufsetzbares Funktionskomponentenoberteil (405) umfasst, und wobei das Komponentenaufbausystem (100) über das Brückenmodul (300, 300-1) mit einer zweiten Funktionskomponente (400) seitlich erweiterbar ist.

6. Komponentenaufbausystem (100) nach Anspruch 5, wobei das Funktionskomponentenoberteil (405) eine Verbindungsschnittstelle für das Funktionskomponentenunterteil und eine weitere Verbindungsschnittstelle für ein auf das Funktionskomponentenoberteil (405) aufsetzbares weiteres Funktionskomponentenoberteil bildet.

7. Komponentenaufbausystem (100) nach Anspruch 5 oder 6, wobei das Funktionskomponentenunterteil (403) eine Komponentenbefestigungseinrichtung (401) zum Halten der Funktionskomponente (400) auf der Tragprofilschiene (200) umfasst.

8. Komponentenaufbausystem (100) nach Anspruch 5, 6 oder 7, wobei das Brückenmodul (300) und/oder die Funktionskomponente (400) auf oder entlang der Tragprofilschiene (200) verschiebbar sind.

9. Komponentenaufbausystem (100) nach einem der vorangehenden Ansprüche 5 bis 8, wobei das Funktionskomponentenunterteil (403) und das Brückenmodul (300) mittels einer formschlüssigen Verbindung (413, 303) verbindbar sind, um die auf die Verbindung zwischen dem Brückenmodul (300) und dem Funktionskomponentenunterteil (403) wirkenden Zugkräfte entlang der Tragprofilschiene (200) aufzunehmen.

10. Komponentenaufbausystem (100) nach einem der vorangehenden Ansprüche, das einen Klemmblock (103) zum Festsetzen des Brückenmoduls (300) gegen die Verschiebbarkeit auf der Tragprofilschiene (200) umfasst, wobei der Klemmblock (103) mit dem Brückenmodul (300) verbindbar ist.

11. Komponentenaufbausystem (100) nach Anspruch 10, wobei das Brückenmodul (300) eine Schwalbenschwanzaussparung (319) zum seitlichen Fixieren des Brückenmoduls (300) an dem Klemmblock (103) umfasst.

12. Komponentenaufbausystem (100) nach Anspruch 10 oder 11, wobei der Klemmblock (103) mit dem Brückenmodul (300) kraftschlüssig oder formschlüssig, insbesondere mittels einer T-Nut/Feder-Verbindung oder einer Schwalbenschwanzverbindung oder einer Schraubverbindung oder einer Klemmverbindung, verbindbar ist.

13. Komponentenaufbausystem (100) nach Anspruch 10, 11 oder 12, wobei der Klemmblock (103) ausgebildet ist, die Tragprofilschiene (200) formschlüssig zu umgreifen und/oder kraftschlüssig zu klemmen.

14. Komponentenaufbausystem (100) nach einem der Ansprüche 5 bis 13, wobei der Klemmblock (103) eine nach außen geführte Erdungsklemme (107) umfasst, welche mit der Tragprofilschiene elektrisch leitend verbindbar ist.

## Claims

1. Modular component assembly system (100) having a profiled carrier rail (200) and at least one bridge module (300) for electrically connecting at least one functional component (400), wherein the bridge module (300) comprises a module latching device (301) for latching the bridge module (300) onto the profiled carrier rail (200), wherein the bridge module (300) comprises bridge connectors, **characterized in that** the bridge module (300) comprises a centring portion (317) for centring the bridge module (300) on the profiled carrier rail (200), wherein the module latching device (301) comprises an elastic latching portion (311) which includes an elongate recess (313) so that the flexibility of the latching section (311) is increased, wherein the latching portion (311) is integrally formed laterally on the bridge module (300), wherein the centring portion (317) protrudes from the rear of the bridge module (300) and is suitable for being mounted between the two carrier profiles of the profiled carrier rail (200), wherein the bridge module (300) has a rail cutout (307) which engages around an edge of the profiled carrier rail (200) and is integrally formed on the bridge module (300).

2. Component assembly system (100) according to claim 1, wherein the bridge module (300) comprises a receiving groove (303) for the insertion of an insertion portion of the functional component (400), in order to absorb tensile forces of the functional component (400) along the profiled carrier rail (200).

3. Component assembly system (100) according to one of the preceding claims, wherein the module latching device (301) comprises a rigid placement portion (323), which engages around the profiled carrier rail (200), and an elastic latching portion (311), arranged opposite the rigid placement portion (323), for latching onto the profiled carrier rail (200).

4. Component assembly system (100) according to one of the preceding claims, wherein the bridge module (300) comprises an arresting device for arresting the bridge module (300) on the profiled carrier rail (200) in a non-displaceable manner.

5. Component assembly system (100) according to one of the preceding claims, which comprises a functional component (400), wherein the functional component (400) comprises a functional component lower part (403), which can be placed onto the bridge module (300, 300-1), and a functional component upper part (405), which can be placed onto the functional component lower part (403), and wherein the component assembly system (100) can be laterally expanded by a second functional component (400) via the bridge module (300, 300-1).

6. Component assembly system (100) according to claim 5, wherein the functional component upper part (405) forms a connection interface for the functional component lower part and a further connection interface for a further functional component upper part which can be placed onto the functional component upper part (405).

7. Component assembly system (100) according to claim 5 or 6, wherein the functional component lower part (403) comprises a component fastening device (401) for retaining the functional component (400) on the profiled carrier rail (200).

8. Component assembly system (100) according to claim 5, 6 or 7, wherein the bridge module (300) and/or the functional component (400) are displaceable on or along the profiled carrier rail (200).

9. Component assembly system (100) according to one of the preceding claims 5 to 8, wherein the functional component lower part (403) and the bridge module (300) can be connected by means of a form-fitting connection (413, 303), in order to absorb the tensile forces along the profiled carrier rail (200) that act on the connection between the bridge module (300) and the functional component lower part (403).

10. Component assembly system (100) according to one of the preceding claims, which comprises a terminal block (103) for securing the bridge module (300) against displacement on the profiled carrier rail (200), wherein the terminal block (103) can be connected to the bridge module (300).

11. Component assembly system (100) according to claim 10, wherein the bridge module (300) comprises a dovetail cutout (319) for laterally fixing the bridge module (300) to the terminal block (103).

12. Component assembly system (100) according to claim 10 or 11, wherein the terminal block (103) can be connected to the bridge module (300) with a force fit or form fit, in particular by means of a T-shaped tongue-and-groove connection or a dovetail connection or a screw connection or a clamping connection.

13. Component assembly system (100) according to claim 10, 11 or 12, wherein the terminal block (103) is configured to engage around the profiled carrier rail (200) with a form fit and/or to clamp the latter with a force fit.

14. Component assembly system (100) according to one of claims 5 to 13, wherein the terminal block (103) comprises a ground terminal (107) which is routed to the outside and which can be electrically conductively connected to the profiled carrier rail.

## Revendications

1. Système modulaire de montage de composants (100) avec un rail profilé support (200) et au moins un module de pontage (300) pour la connexion électrique d'au moins un composant fonctionnel (400), où le module de pontage (300) comprend un dispositif d'enclenchement de module (301) pour l'enclenchement du module de pontage (300) sur le rail profilé support (200), le module de pontage (300) comprenant des fiches de pontage, **caractérisé en ce que**
le module de pontage (300) présente un segment de centrage (317) pour le centrage du module de pontage (300) sur le rail profilé support (200), le dispositif d'enclenchement de module (301) comprenant un segment d'enclenchement élastique (311) avec un évidement oblong (313), de manière à élever la flexibilité du segment d'enclenchement (311), le segment d'enclenchement (311) étant formé d'un seul tenant sur le côté du module de pontage (300), le segment de centrage (317) faisant saillie sur la face arrière du module de pontage (300) et étant prévu pour être monté entre les deux profilés support du rail profilé support (200), le module de pontage (300) présentant un évidement pour rail (307) où est engagé un bord du rail profilé support (200) et est formé d'un seul tenant sur le module de pontage (300).

2. Système de montage de composants (100) selon la revendication 1, où le module de pontage (300) présente une rainure de réception (303) pour la mise en place d'un segment d'insertion du composant fonctionnel (400), afin de supporter les efforts de traction du composant fonctionnel (400) le long du rail profilé support (200).

3. Système de montage de composants (100) selon l'une des revendications précédentes, où le dispositif d'enclenchement de module (301) comprend un segment de mise en place (323) entourant le rail profilé support (200) et un segment d'enclenchement à élasticité de ressort (311) opposé au segment de mise en place rigide (323) pour l'enclenchement sur le rail profilé support (200).

4. Système de montage de composants (100) selon l'une des revendications précédentes, où le module de pontage (300) comprend un dispositif de blocage pour empêcher le coulissement du module de pontage (300) sur le rail profilé support (200).

5. Système de montage de composants (100) selon l'une des revendications précédentes, comprenant un composant fonctionnel (400), ledit composant fonctionnel (400) comprenant une pièce inférieure (403) de composant fonctionnel, pouvant être mise en place sur le module de pontage (300, 300-1), et une pièce supérieure (405) de composant fonctionnel pouvant être mise en place sur la pièce inférieure (403) de composant fonctionnel, et où le système de montage de composants (100) étant extensible sur les côtés par un deuxième composant fonctionnel (400) au moyen du module de pontage (300, 300-1).

6. Système de montage de composants (100) selon la revendication 5, où la pièce supérieure (405) de composant fonctionnel forme une interface de connexion pour la pièce inférieure de composant fonctionnel et une autre interface de connexion pour une autre pièce supérieure de composant fonctionnel pouvant être mise en place sur la pièce supérieure (405) de composant fonctionnel.

7. Système de montage de composants (100) selon la revendication 5 ou la revendication 6, où la pièce inférieure (403) de composant fonctionnel comprend un dispositif de fixation de composant (401) pour le maintien du composant fonctionnel (400) sur le rail profilé support (200).

8. Système de montage de composants (100) selon la revendication 5, la revendication 6 ou la revendication 7, où le module de pontage (300) et/ou le composant fonctionnel (400) sont mobiles sur ou le long du rail profilé support (200).

9. Système de montage de composants (100) selon l'une des revendications 5 à 8, où la pièce inférieure (403) de composant fonctionnel et le module de pontage (300) peuvent être raccordés par connexion à engagement positif (413, 303) afin de supporter les efforts de traction exercés sur la liaison entre le module de pontage (300) et la pièce inférieure (403) de composant fonctionnel le long du rail profilé support (200).

10. Système de montage de composants (100) selon l'une des revendications précédentes, comprenant un bloc de serrage (103) pour empêcher le coulissement du module de pontage (300) sur le rail profilé support (200), ledit bloc de serrage (103) pouvant être raccordé au module de pontage (300).

11. Système de montage de composants (100) selon la revendication 10, où le module de pontage (300) présente un évidement en queue d'aronde (319) pour la fixation latérale du module de pontage (300) contre le bloc de serrage (103).

12. Système de montage de composants (100) selon la revendication 10 ou la revendication 11, où le bloc de serrage (103) peut être raccordé au module de pontage (300) par connexion à force ou par engagement positif, en particulier au moyen d'une connexion à rainure en T et languette ou à queue d'aronde ou à vis ou à serrage.

13. Système de montage de composants (100) selon la revendication 10, la revendication 11 ou la revendication 12, où le bloc de serrage (103) est prévu pour entourer par correspondance de forme le rail profilé support (200) et/ou à serrer celui-ci par force.

14. Système de montage de composants (100) selon l'une des revendications 5 à 13, où le bloc de serrage (103) comprend une borne de terre (107) reliée à l'extérieur, pouvant être raccordée au rail profilé support de manière électriquement conductrice.
